# EUROPEAN PATENT SPECIFICATION

(11) **EP 2 169 690 B1**
(45) Date of publication and mention of the grant of the patent: **29.08.2012**
(21) Application number: 08164976.6
(22) Date of filing: 24.09.2008
(51) Int. Cl.: H01F 27/14, E21B 33/038

(54) **Pressure compensator**
Druckkompensator
Compensateur de pression

(43) Date of publication of application: 31.03.2010
(73) Proprietor: ABB Technology AG, 8050 Zürich (CH)
(72) Inventor: Virtanen, Esa, 65100, Vaasa (FI); Haldin, Torvald, 66580, Kuni (FI); Missing, Kim, 66510, Merikaarto (FI)
(74) Representative: Valkeiskangas, Tapio Lassi Paavali

(56) References cited:
- WO-A-2007/055588
- CN-Y- 201 054 295
- GB-A- 1 023 452
- JP-A- 6 310 343
- JP-A- 56 162 815
- US-A1- 2007 074 872

## Description

The invention relates to a pressure compensator configured to compensate volume variations of an insulation medium or other liquid of a subsea installation, comprising a first bellows chamber comprising a first bellows part, the first bellows chamber being in flow connection with an insulation medium or other liquid chamber of the subsea installation and the walls of the first bellows chamber being configured to separate the insulating medium from surroundings.

Subsea installations are assemblies used under water. Said assemblies can be installed for example on the bottom ground of a sea. As an example of said subsea installations power transformers used under water can be mentioned. Typically these power transformers use insulation medium, i.e. the transformers are fluid insulated ones having for example transformer oil in a transformer tank. Examples of the other subsea liquid filled objects are subsea motors, subsea switchgears, subsea converters, rectifiers and hydraulic store tanks.

The subsea installations described above are used for example in modern oil and gas production in which the collection, separation, boosting and transport of production fluids takes place on the seabed. These processes require large amounts of power that has to be transferred from a remote location at suitable voltages and currents for minimum power loss, to the subsea installations. The transport of the power preferably takes place at high voltages and low current to ensure minimum losses. When the power arrives at the subsea location, the power has to be transformed into more usable voltages and currents for the various specific subsea applications, such as for example the powering of pumps and compressors.

The large power requirements result in the need of large transformers placed in a protective environment inside a large vessel, i.e. a tank. The transformer tank must be filled with an insulating medium that ensures optimal working conditions for the transformer over many years. The preferred insulating medium comprises transformer oil that contributes towards dissipating heat and preventing shorts and flashovers. In new big subsea transformers the size of the transformer tank is typically in the order of 10-30 cubic meters containing 10 000 - 30 000 litres of transformer oil. The water temperature variations, heat produced by the transformer and the properties of typical transformer oil result in oil volume variation in the order of several hundred litres or more. As the size of a transformer tank increases, the problems and need of compression and expansion also increase accordingly.

As told above subsea installations, for example subsea transformers need pressure compensators to keep the pressure of the insulation medium used, for example the pressure of oil inside the transformer, close to the water pressure outside the transformer to avoid heavy mechanical structures against pressure. Also the cooling is easier when thinner wall thickness can be applied. The hydrostatic pressure of the water will increase circa 10 bars for each 100 m water depth increase and the pressure difference between the oil inside and the water outside is typically needed to be less that 1 bar. The subsea transformers filled with insulation oil will be exposed to oil compression and expansion due to temperature variation of the surrounding, due to load variation causing also the variation of the oil temperature and due to hydrostatic pressure of the sea water. The oil volume variation due to temperature variation is caused by oil property having non-zero thermal expansion coefficient and the oil volume variation due to pressure variation is caused by close to zero pressure-volume coefficient of the oil.

For construction point of views and reliability reasons the transformer vessels or other equipment tanks described above are typically rigid and constant volume structures and when transformer or equipment sizes are increasing this means that the pressure inside the transformer or other equipment must be close to water pressure around the transformer or the other equipment. Owing to the facts above said subsea transformers or the other equipments need one or several pressure compensators to keep the oil pressure inside the transformer close to the water pressure outside the transformer. Said pressure compensators are structures with variable volume oil or other liquid filled containers outside the transformer or the other equipment. Said variable volume containers are also in flow connection with the transformer oil space or the other equipment liquid space.

There are several different solutions for subsea pressure compensators. As examples of the prior art solutions PCT document WO 2007/055588 A1 and US Patent Application US 2004/0051615 A1. All prior art subsea pressure compensators, for example those mentioned above, have only one wall or barrier between the sea water and the oil inside. Said fact is a serious problem of the prior art subsea pressure compensators. This means that if one barrier or wall will have a failure producing leakage between the oil and the water, the water will enter into the transformer causing fatal electrical failure of the transformer and so end of the transformer operation. The other equipment will have also serious consequences like for example electrical failures if the water will leak in. Said leak problem relates mainly to corrosion caused by the sea water, i.e. prior art pressure compensators are not particularly resistant against corrosion caused by sea water. The sensitivity of the corrosion may be a risk with metallic bellows type pressure compensators because the wall of the bellows must be very thin to reach required flexibility. This may be the situation even when cathodic protection will be used.

There are also known solutions with which properties of different bellows structures against corrosion are improved. As examples of said solutions JP 9176766, JP 2000046181, EP 0 281 685 and US 5 893 681 can be mentioned. These known solutions are not however suitable in subsea conditions.

As further examples of the prior art US 2007/074872 A1 and GB-A-1 023 452 can be mentioned.

The object of the present invention is to obtain a pressure compensator, which eliminates the problems of the prior art. This is obtained by the present invention. The present invention is characterized in that the first bellows chamber is surrounded by a second bellows chamber comprising a second bellows part, the second bellows chamber being configured to form a closed intermediate space around the first bellows chamber, the walls of the second bellows chamber being configured to separate at least the bellows parts of the first bellows chamber from the surrounding sea water, the second bellows chamber being further filled with a intermediate medium and the second bellows part of the second bellows chamber being made of a material resistant to surrounding sea water.

An advantage of the invention is that the problems relating to sea water corrosion are eliminated very efficiently. The present invention is also simple and therefore manufacturing and maintenance costs are low.

The invention will be described in the following in detail by means of the examples shown in the attached drawing, in which
Figure 1 shows schematically the basic structure and operation principle of the pressure compensator of the invention,
Figures 2 - 5 show different embodiments of the invention,
Figure 6 shows a structural detail of one embodiment of the invention and
Figure 7 shows schematically a subsea transformer provided with pressure compensators of the invention.

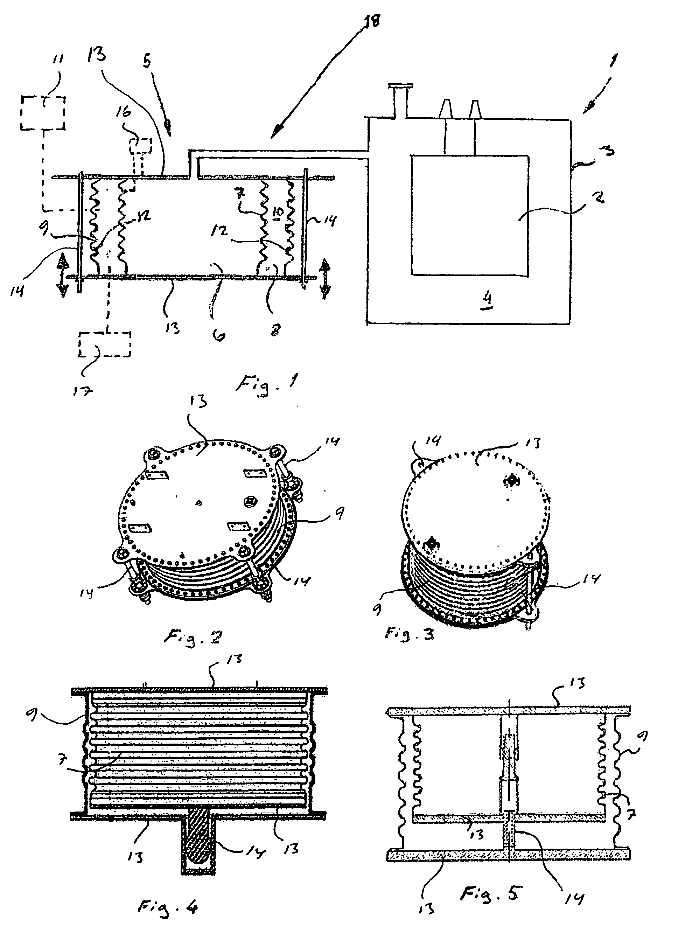

Figure 1 shows schematically the basic structure of the invention and how the present invention operates in connection with a subsea installation. In the example of Figure 1 the subsea installation is a subsea transformer. Reference number 1 shows generally the subsea transformer. The subsea transformer 1 comprises the transformer unit 2 and a tank 3. The tank is filled with insulation medium, i.e. in this case transformer oil. The tank 3 forms an insulation chamber around the transformer unit 2.

In order to compensate volume variations of the insulating medium 4 there is a pressure compensator 5. The pressure compensator 5 comprises a first bellows chamber 6. The first bellows chamber 6 comprises a first bellows part 7. The first bellows part 7 is made of a suitable material, for example of steel.

The first bellows chamber 6 is through a pipe or channel system 18 in flow connection with the insulation chamber formed by the tank 3 so that said bellows chamber 6 can compensate volume variations of the insulating medium 4.

The assembly shown in Figure 1 is wholly surrounded with sea water, i.e. the assembly is placed on the bottom of the sea.

The matters above are widely known in the fields and therefore said matters are not described here in detail.

As told before the problems in prior art solutions relate to corrosion damages in the bellows part of the pressure compensator, ie. sea water causes corrosion problems in the first bellows part.

According to the basic idea of the invention the first bellows chamber 6 is surrounded by a second bellows chamber 8 comprising a second bellows part 9. The second bellows chamber 8 is configured to form a closed intermediate space around the first bellows chamber. The walls of the second bellows chamber are configured to separate at least the bellows parts 7 of the first bellows chamber 6 from the surrounding sea water. The second bellows chamber 8 is further filled with an intermediate medium 10. The second bellows part 9 of the second bellows chamber 8 is preferably made of a material resistant to surrounding sea water.

In other words the expansive and compressive element of the pressure compensator has two barriers or walls between transformer related space and seawater.

The inner barrier, i.e. the first bellows part 7 is made of metallic bellows construction and the outer barrier, i.e. the second bellows part 9 is made of rubber material or rubber like material. Said rubber like material can be for example appropriate plastic material or a mixture with rubber material and plastic material. The space between the first bellows part 7 and the second bellows part 9, i.e. the second bellows chamber 8 is filled with the same transformer oil or oil which is mixable with the transformer oil 4 in the first bellows chamber 6 and in the tank 3. There is however no exchange of oil through the first bellows part 7.

The second bellows part 9 made of rubber material or like protects the first bellows part 7 made of metal material from corrosion. In this connection it is important to realise that the first bellows part 7 due to flexibility needed must have a typically thin wall construction, and therefore corrosion matters are very important as regards the operation of the device. The typical wall thickness of the first bellows part 7 is in 1 mm scale. In order to have more flexibility and reliability the first bellows part 7 can be constructed also with one or more metallic layers.

The small volume changes of the closed intermediate oil space, i.e. the second bellows chamber 8 between the first and the second bellows parts must also be compensated. This is carried out e.g. by making the second bellows part 9 so that it is able also to expand in radial direction due to pressure variation or by using an additional small pressure compensator 11 connected to the intermediate space, i.e. to the second d bellows chamber 8. Said eventual additional small compensator can have one barrier construction without loosing the double barrier feature of the whole pressure compensator.

The rubber material used in the second bellows part 9 can be for example Nitrile rubber, which is resistant against sea water and after suitable treatment compatible wit the transformer oil too.

The second bellows part 9 can be made wholly of said rubber or rubber like material. It is however quite possible to put appropriate strengthening material or several strengthening materials to the bellows part material, for example inside of the bellows wall as shown with a reference number 12 in Figure 1.

In this connection it is however important to realize that it is quite possible instead of the rubber material bellows to use the second bellows part 9 made of steel material. The steel material used can for example be selected so that it is as resistant as possible against sea water. Said second bellows part 9 made of steel also protects efficiently the first bellows part 7 against corrosion caused by sea water before the second bellows part is through corroded. The pressure compensator can however be changed before the first bellows is corroded.

The other walls of the pressure compensator, which are not changing their shape and size, for example end walls 13 of the tubular form bellows parts can be made for example of thick enough one layer metallic material, like e.g. stainless steel plates. Said walls can however be for example two-layer construction like rubber material/metal material walls.

The pressure compensator of the invention can also be provided with guiding rods 14 for guiding the first and the second bellows parts to move during compression and/or expansion along defined paths. Said compression and expansion movements of the bellows parts are shown by arrows in Figure 1. The number of said guiding rods can be chose freely according to the existing need. It is quite possible for example to materialize the pressure compensator without said guiding rods. Figure 2 shows an embodiment of the invention with four guiding rods 14 and Figure 3 shows another embodiment of the invention with two guiding rods 14. In the embodiments of Figures 1 - 3 the guiding rods 14 are located circumferentially outside the bellows parts. Said placement is however not the only possibility but said guiding rods 14 can also be place in the bellows parts. Said embodiments are shown in Figures 4 and 5 in which one guiding rod is used and said guiding rod 14 is placed centrally in the bellows parts. The end plates 13 are also materialized differently in the embodiments of Figures 4 and 5 when compared to the embodiments of Figures 1 - 3. In the embodiments of Figures 4 and 5 the first bellows part 7 and the second bellows part 9 have both at one end thereof an end plate of its own, and use a common end plate at the other ends thereof.

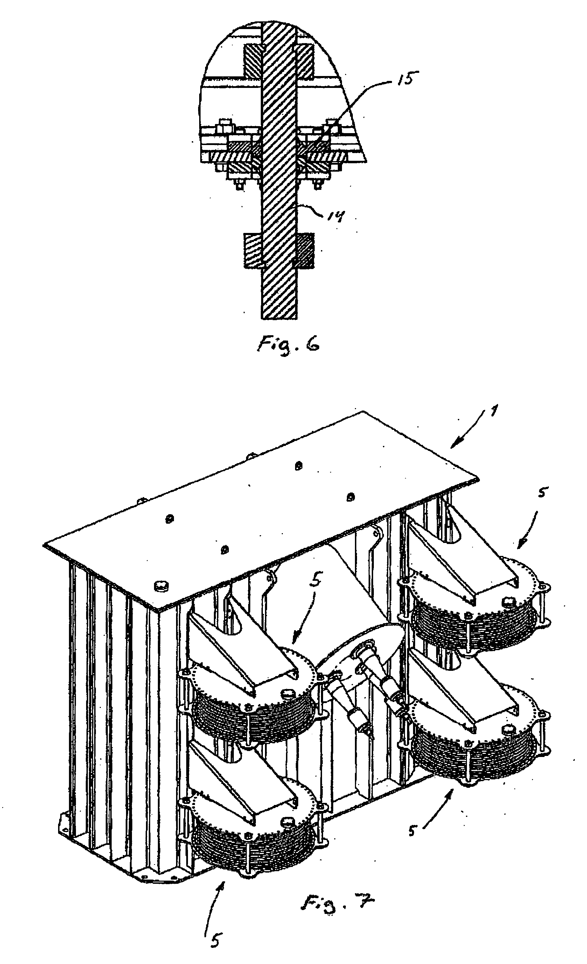

The guiding rods 14 of the pressure compensator are connected movable with guiding bushings 15 around the guiding rods to the movable parts of the pressure compensator. The material of the guiding bushings 15 is selected so that the bushings do not easily jam and so that moving bushings will keep the surfaces of the guiding rods clean from marine fouling and other eventual impurities, which might cause jamming. Any appropriate material can be used for the guiding bushings 15, for example several plastic materials are suitable. As an example of particularly materials nylon can be mentioned. Figure 6 shows an example how said guiding bushings 15 can be materialized for example in the embodiments shown for example in Figures 2 and 3. Said guiding bushings can be made as replaceable parts.

The guiding bushings 15 of the guiding rods can however be made so that if these should however jam the bushings will break due to compression and expansion movement forces and said breaking will release the jamming. After that the wider metallic part of the bushing will guide the movements. Nylon is suitable material to have this breaking feature too.

The guiding rods and the related bushings can also be formed so that they can also be used as indicators of the pressure compensator operation state as indicating the bushing position, i.e. the guiding rod arrangement can also act as an indicator of the movements of the bellows parts. The bushing position can be inspected by any appropriate ROV (Remote Operate Vehicle) camera when the rods are on the outer surface of the outer expanding and compressing barrier.

The number of the pressure compensators connected parallel to the subsea installation, for example to the subsea transformer or to some other possible object to be compensated, is selected so that the total oil volume required can be compensated.

The pressure compensator can also include electrically based corrosion protection means or some other type of corrosion protection means. Said corrosion protection means can be situated also inside the pressure compensator to protect the first bellows part made of metal material. Reference number 16 in Figure 1 shows schematically said corrosion protection means.

The pressure compensator of the invention can also be provided with monitor means for monitoring the amount of sea water eventually leaked into the intermediate space, i.e. into the second bellows chamber 8. Reference number 17 in Figure 1 shows said monitoring means.

As discussed above the number of the pressure compensators used in connection with a subsea installation can vary according to the existing need. Typical compensation volume of the pressure compensators required in near future big subsea transformers in hundreds of litres, for example 200 litres, and typical number of compensators needed in one big subsea transformer is from 2 to 6 compensator units. As an example Fig. 7 shows a subsea transformer with four pressure compensators.

The embodiments described above are not intended to restrict the invention but only to clarify the basic idea of the invention. It is quite clear that details can be varied freely within the scope of the claims. The invention is described here in connection with subsea transformers. The invention is however not restricted solely to subsea transformers but the invention can also be used in connection with all subsea installations using insulation medium and needing compensation of said insulation medium etc. Insulation medium need not be transformer oil but any other medium or fluid can be used according to the existing need.

## Claims

1. Pressure compensator configured to compensate volume variations of an insulation medium or other liquid of a subsea installation (1), comprising a first bellows chamber (6) comprising a first bellows part (7), the first bellows chamber being in flow connection with an insulation medium or liquid chamber of the subsea installation and the walls of the first bellows chamber (6) being configured to separate the insulating medium from surroundings, **characterized in that** the first bellows chamber (6) is surrounded by a second bellows chamber (8) comprising a second bellows part (9), the second bellows chamber (8) being configured to form a closed intermediate space around the first bellows chamber (6), the walls of the second bellows chamber being configured to separate at least the bellows parts (7) of the first bellows chamber (6) from the surrounding sea water, the second bellows chamber (8) being further filled with an intermediate medium (10).

2. Pressure compensator of claim 1, **characterized in that** the second bellows part (9) of the second bellows chamber (8) is made of a material resistant to surrounding sea water.

3. Pressure compensator of claim 2, **characterized in that** the second bellows part (9) is made of rubber or plastic material or a mixture of said two materials.

4. Pressure compensator of claim 1, **characterized in that** the second bellows part (9) is made of steel material.

5. Pressure compensator of claim 1, **characterized in that** the second bellows part (9) of the second bellows chamber (8) is configured to compensate the volume changes of the intermediate medium (10).

6. Pressure compensator of claim 1, **characterized in that** the closed intermediate space is provided with an additional pressure compensator (11) which is configured to compensate the volume changes of the intermediate medium (10).

7. Pressure compensator of claim 1, **characterized in that** the intermediate medium (10) is the same medium as the insulation medium (4) of the subsea installation (1) or a medium mixable with the insulation medium (4) of the subsea installation (1).

8. Pressure compensator of claim 3, **characterized in that** the second bellows part (9) is provided with strengthening material or materials (12).

9. Pressure compensator of claim 1, **characterized in that** the first and the second bellows parts (7,9) are tubular parts and at least one guiding rod arrangement (14) is arranged to guide the first and the second bellows parts (7,9) to move along defined paths.

10. Pressure compensator of claim 9, **characterized in that** the guiding rod arrangements (14) comprise guiding bushings (15) comprising replaceable parts, the replaceable parts being configured to brake due to compression or expansion movement forces created by the bellows parts if said forces exceed a pre-determined level so that after said breaking the remaining parts of the bushings carry out guiding.

11. Pressure compensator of claim 9, **characterized in that** the guiding rod arrangements (14) are configured to act as an indicator of the movements of the bellows parts.

12. Pressure compensator of claim 1, **characterized in that** the intermediate space is provided with measuring elements (17) configured to monitor eventual amount of sea water in the intermediate space.

13. Pressure compensator of claim 1, **characterized in that** the pressure compensator is provided with a corrosion protecting means (16).

14. Pressure compensator of claim 1, **characterized in that** the subsea installation (1) is a subsea transformer.

15. Pressure compensator of claim 14, **characterized in that** the insulation medium (4) is transformer oil.

## Patentansprüche

1. Ein Druckkompensator, der konfiguriert ist, Volumenvariationen eines Isoliermediums oder einer anderen Flüssigkeit einer Unterwasserinstallation (1) zu kompensieren, welcher eine erste Blasebalgkammer (6) aufweist, die einen ersten Blasebalgteil (7) aufweist, wobei die erste Blasebalgkammer in Strömungsverbindung mit einem Isoliermedium oder einer Flüssigkeitskammer der Unterwasserinstallation steht und die Wände der ersten Blasebalgkammer (6) angeordnet sind, das Isoliermedium von der Umgebung zu trennen, **dadurch gekennzeichnet, dass** die erste Blasebalgkammer (6) von einer zweiten Blasebalgkammer (8) umgeben ist, die einen zweiten Blasebalgteil (9) aufweist, wobei die zweite Blasebalgkammer (8) angeordnet ist, einen geschlossenen Zwischenraum um die erste Blasebalgkammer (6) herum zu bilden, wobei die Wände der zweiten Blasebalgkammer angeordnet sind, mindestens die Blasebalgteile (7) der ersten Blasebalgkammer (6) von dem umgebenden Meerwasser zu trennen, wobei die zweite Blasebalgkammer (8) weiterhin mit einem Zwischenmedium (10) gefüllt ist.

2. Ein Druckkompensator gemäß dem Patentanspruch 1, **dadurch gekennzeichnet, dass** der zweite Blasebalgteil (9) der zweiten Blasebalgkammer (8) aus einem Material hergestellt ist, das dem umgebenden Meerwasser standhält.

3. Ein Druckkompensator gemäß dem Patentanspruch 2, **dadurch gekennzeichnet, dass** der zweite Blasebalgteil (9) aus Gummi- oder Plastikmaterial oder einer Mischung der besagten beiden Materialien hergestellt ist.

4. Ein Druckkompensator gemäß dem Patentanspruch 1, **dadurch gekennzeichnet, dass** der zweite Blasebalgteil (9) aus Stahlmaterial hergestellt ist.

5. Ein Druckkompensator gemäß dem Patentanspruch 1, **dadurch gekennzeichnet, dass** der zweite Blasebalgteil (9) der zweiten Blasebalgkammer (8) konfiguriert ist, die Volumenveränderungen des Zwischenmediums (10) zu kompensieren.

6. Ein Druckkompensator gemäß dem Patentanspruch 1, **dadurch gekennzeichnet, dass** der geschlossene Zwischenraum mit einem zusätzlichen Druckkompensator (11) versehen ist, der konfiguriert ist, die Volumenveränderungen des Zwischenmediums (10) zu kompensieren.

7. Ein Druckkompensator gemäß dem Patentanspruch 1, **dadurch gekennzeichnet, dass** das Zwischenmedium (10) dasselbe Medium ist wie das Isoliermedium (4) der Unterwasserinstallation (1) oder ein mit dem Isoliermedium (4) der Unterwasserinstallation (1) mischbares Medium.

8. Ein Druckkompensator gemäß dem Patentanspruch 3, **dadurch gekennzeichnet, dass** der zweite Blasebalgteil (9) mit einem oder mehreren verstärkenden Materialien (12) versehen ist.

9. Ein Druckkompensator gemäß dem Patentanspruch 1, **dadurch gekennzeichnet, dass** die ersten und die zweiten Blasebalgteile (7, 9) röhrenförmige Teile sind und mindestens eine Steuerstangenanordnung (14) angeordnet ist, den ersten und den zweiten Blasebalgteil (7, 9) zu steuern, sich einen im Voraus definierten Pfad entlang zu bewegen.

10. Ein Druckkompensator gemäß dem Patentanspruch 9, **dadurch gekennzeichnet, dass** die Steuerstangenanordnungen (14) Steuerbuchsen (15) aufweisen, die ersetzbare Teile aufweisen, wobei die ersetzbaren Teile angeordnet sind, wegen Kompressions- oder Expansionsbewegungskräften, die durch die Blasebalgteile erzeugt werden, zu bremsen, falls besagte Kräfte ein im Voraus bestimmtes Niveau überschreiten, so dass nach dem besagten Bremsen die verbleibenden Teile der Buchsen das Steuern durchführen.

11. Ein Druckkompensator gemäß dem Patentanspruch 9, **dadurch gekennzeichnet, dass** die Steuerstangenanordnungen (14) angeordnet sind, als Indikator der Bewegungen der Blasebalgteile zu funktionieren.

12. Ein Druckkompensator gemäß dem Patentanspruch 1, **dadurch gekennzeichnet, dass** der Zwischenraum mit Messelementen (17) versehen ist, die angeordnet sind, eine eventuelle Menge von Meereswasser in dem Zwischenraum zu überwachen.

13. Ein Druckkompensator gemäß dem Patentanspruch 1, **dadurch gekennzeichnet, dass** der Druckkompensator mit einem Korrosionsschutzmittel (16) versehen ist.

14. Ein Druckkompensator gemäß dem Patentanspruch 1, **dadurch gekennzeichnet, dass** die Unterwasserinstallation (1) ein Unterwassertransformator ist.

15. Ein Druckkompensator gemäß dem Patentanspruch 14, **dadurch gekennzeichnet, dass** das Isoliermedium (4) Transformatorenöl ist.

## Revendications

1. Compensateur de pression configuré en vue de compenser des variations de volume d'un milieu ou autre liquide isolant dans une installation sous-marine (1), comprenant un premier compartiment (6) à soufflet comprenant un premier élément soufflet (7), le premier compartiment à soufflet étant en communication fluidique avec un compartiment de milieu ou liquide isolant de l'installation sous-marine et les parois du premier compartiment (6) à soufflet étant configurées pour séparer le milieu isolant de l'environnement, **caractérisé en ce que** le premier compartiment (6) à soufflet est entouré d'un second compartiment (8) à soufflet comprenant un second élément soufflet (9), le second compartiment (8) à soufflet étant configuré pour former un espace intermédiaire clos autour du premier compartiment (6) à soufflet, les parois du second compartiment à soufflet étant configurées pour séparer au moins l'élément soufflet (7) du premier compartiment (6) à soufflet de l'eau de mer environnante, le second compartiment (8) à soufflet étant en outre rempli d'un milieu intermédiaire (10).

2. Compensateur de pression selon la revendication 1, **caractérisé en ce que** le second élément soufflet (9) du second compartiment (8) à soufflet se compose d'un matériau résistant à l'eau de mer environnante.

3. Compensateur de pression selon la revendication 2, **caractérisé en ce que** le second élément soufflet (9) se compose de caoutchouc ou de plastique ou d'un mélange desdits deux matériaux.

4. Compensateur de pression selon la revendication 1, **caractérisé en ce que** le second élément soufflet (9) se compose d'acier.

5. Compensateur de pression selon la revendication 1, **caractérisé en ce que** le second élément soufflet (9) du second compartiment (8) à soufflet est configuré en vue de compenser les changements de volume du milieu intermédiaire (10).

6. Compensateur de pression selon la revendication 1, **caractérisé en ce que** l'espace intermédiaire clos est pourvu d'un compensateur de pression supplémentaire (11) qui est configuré en vue de compenser les changements de volume du milieu intermédiaire (10).

7. Compensateur de pression selon la revendication 1, **caractérisé en ce que** le milieu intermédiaire (10) est le même milieu que le milieu isolant (4) de l'installation sous-marine (1) ou un milieu pouvant être mélangé au milieu isolant (4) de l'installation sous-marine (1).

8. Compensateur de pression selon la revendication 3, **caractérisé en ce que** le second élément soufflet (9) est pourvu d'un matériau ou de matériaux de renforcement (12).

9. Compensateur de pression selon la revendication 1, **caractérisé en ce que** les premier et second éléments soufflets (7, 9) sont des éléments tubulaires et au moins un agencement de tige de guidage (14) est conçu pour guider les premier et second éléments soufflets (7, 9) pour qu'ils se déplacent le long de voies définies.

10. Compensateur de pression selon la revendication 9, **caractérisé en ce que** les agencements de tige de guidage (14) comprennent des manchons de guidage (15) comprenant des éléments remplaçables, les éléments remplaçables étant configurés en vue de freiner en raison de forces de déplacement de compression ou de dilatation créées par les éléments soufflets si lesdites forces dépassent un niveau prédéterminé de sorte qu'après ledit freinage, les autres éléments des manchons effectuent le guidage.

11. Compensateur de pression selon la revendication 9, **caractérisé en ce que** les agencements de tige de guidage (14) sont configurés pour servir d'indicateur des déplacements des éléments soufflets.

12. Compensateur de pression selon la revendication 1, **caractérisé en ce que** l'espace intermédiaire est pourvu d'éléments de mesure (17) configurés en vue de contrôler la quantité éventuelle d'eau de mer dans l'espace intermédiaire.

13. Compensateur de pression selon la revendication 1, **caractérisé en ce que** le compensateur de pression est pourvu d'un moyen de protection contre la corrosion (16).

14. Compensateur de pression selon la revendication 1, **caractérisé en ce que** l'installation sous-marine (1) est un transformateur sous-marin.

15. Compensateur de pression selon la revendication 14, **caractérisé en ce que** le milieu isolant (4) est de l'huile de transformateur.
